Europäisches Patentamt

European Patent Office

Office européen des brevets

(19)

(11) **EP 0 551 038 B1**

(12) **FASCICULE DE BREVET EUROPEEN**

(45) Date de publication et mention
de la délivrance du brevet:
**14.02.1996   Bulletin 1996/07**

(51) Int Cl.6: **H01L 27/02**, H02H 9/04

(21) Numéro de dépôt: **92403550.4**

(22) Date de dépôt: **23.12.1992**

(54) **Protection générale d'un circuit intégré contre les surcharges permanentes et décharges électrostatiques**

**Allgemeine Schutzvorrichtung eines integrierten Schaltkreises gegen Überlastungen und elektrostatische Entladungen**

**General protection of an IC against overloading and electrostatic discharges**

(84) Etats contractants désignés:
**DE FR GB IT**

(30) Priorité: **31.12.1991 FR 9116411**

(43) Date de publication de la demande:
**14.07.1993   Bulletin 1993/28**

(73) Titulaire:
**SGS-THOMSON MICROELECTRONICS S.A.**
**F-94250 Gentilly (FR)**

(72) Inventeur: **Tailliet, François**
**F-75116 Paris (FR)**

(74) Mandataire:
**Schmit, Christian Norbert Marie et al**
**F-75116 Paris (FR)**

(56) Documents cités:
**EP-A- 0 126 184            US-A- 3 879 640**
**US-A- 4 460 935            US-A- 4 922 371**
**US-A- 4 939 616**

• **PATENT ABSTRACTS OF JAPAN, vol 11, no 042, P545, 19.09.86; & JP-A-61211715**

**EP 0 551 038 B1**

**Description**

L'invention concerne les circuits intégrés et leur protection selon un principe commun contre à la fois les décharges électrostatiques, les surcharges permanentes comme les inversions de polarité ou surtensions, les phénomènes induits comme les phénomènes de verrouillage.

L'invention permet de protéger les circuits intégrés dans un large domaine contre des destructions volontaires malveillantes ou frauduleuses et les destructions involontaires provoquées par l'électricité statique, la foudre, les orages magnétiques ou par des fausses manoeuvres ou erreurs humaines (inversion de polarité, surtension).

Or l'utilisation généralisée des circuits intégrés fait apparaître de nouveaux problèmes, en particulier dans le domaine de la monétique avec les cartes bancaires qui utilisent un unique microcircuit pour toute électronique. Il n'y a donc plus d'environnement électronique possible qui pourrait permettre une protection externe du circuit intégré. Par exemple, les composants discrets de protection, tels les diodes d'écrêtage spéciales et résistances non linéaires utilisées comme protection aux surcharges permanentes, ne peuvent plus être utilisés.

Par ailleurs pour ces mêmes raisons, et aussi parce que les technologies nouvelles conduisent à des circuits de plus en plus fragiles, il convient de cerner tous les phénomènes destructeurs et de protéger l'ensemble du circuit intégré et non plus seulement certaines entrées ou sorties vis à vis de certains phénomènes destructifs. Il devient ainsi nécessaire de rendre entièrement "autoprotégé" le circuit intégré, à la fois aux décharges électrostatiques et aux surtensions permanentes y compris les inversions de polarité, par une structure de protection intégrée.

Habituellement on cherche pour un type de patte de connexion donné à cerner le problème qui s'y pose pour un phénomène particulier et à le résoudre. Par exemple dans le brevet FR 2681193 du même inventeur, on place ainsi un dispositif suiveur de tension entre le drain et la grille d'un transistor de sortie à drain ouvert comme dispositif de protection contre les décharges électrostatiques qui affectent l'oxyde de grille à l'endroit du drain. Le brevet US 4,922,371 décrit un autre circuit de protection contre les décharges électrostatiques pour des circuits intégrés.

Dans l'invention, on propose une stratégie de protection applicable simultanément à tous les phénomènes destructifs. La solution originale de l'invention consiste à modifier la caractéristique d'entrée courant-tension de chacune des pattes de connexion du circuit intégré par rapport à un noeud électrique commun, interne au circuit intégré. Avantageusement le noeud électrique interne est le noeud électrique du substrat semi-conducteur du circuit intégré. Alors que le substrat semi-conducteur est habituellement court-circuité à une patte de connexion à une tension de référence externe, par exemple un substrat P est habituellement polarisé à la masse Vss, dans l'invention on isole le substrat semi-conducteur de cette patte de connexion, et on le polarise en interne. Cette solution originale permet en outre de résoudre avantageusement le problème de la protection aux inversions de polarité.

L'invention concerne donc un circuit intégré réalisé à partir d'un substrat semi-conducteur d'un premier type de dopage, comportant des pattes de connexion de noeuds fonctionnels internes à des signaux externes, le circuit intégré disposant d'une première référence de tension interne délivrée par une patte de connexion à une première source de tension externe, le substrat semi-conducteur étant polarisé à une deuxième référence de tension interne, caractérisé en ce qu'il comprend un dispositif de protection contre les surtensions entre chacune des pattes de connexion et le substrat semi-conducteur, une diode connectée entre le substrat semi-conducteur et une patte de connexion à une deuxième source de tension de référence externe, et une résistance de polarisation (RP) connectée entre la première et la deuxième référence de tension interne, en sorte que la diode est polarisée en direct en polarisation normale du circuit intégré et en inverse en polarisation inversée du circuit intégré, pour isoler le substrat semi-conducteur de la patte de connexion à la deuxième source de tension externe à laquelle il est habituellement court-circuité.

On obtient ainsi une protection générale du circuit intégré contre l'ensemble des phénomènes destructeurs.

L'invention concerne aussi un procédé de fabrication d'un circuit intégré polarisé par une première source de tension externe et une deuxième source de tension externe, caractérisé en ce que l'on réalise dans un substrat semi-conducteur d'un premier type de dopage, une diffusion d'un second type de dopage, connectée à la deuxième source de tension externe, et une résistance de polarisation connectée sur une borne à la première référence de tension interne et sur l'autre borne à une diffusion du premier type de dopage pour polariser le substrat à une deuxième référence de tension interne, le substrat et la diffusion d'un second type de dopage formant une diode polarisée en direct en polarisation normale du circuit intégré et en inverse en polarisation inverse du circuit intégré, et le circuit intégré comprenant un dispositif de protection aux surtensions entre chaque patte de connexion et le substrat.

D'autres caractéristiques et avantages de l'invention apparaîtront à la lecture de la description détaillée qui suit, faite à titre indicatif et non limitatif de l'invention et en référence aux dessins annexés dans lesquels :

- la figure 1 est un schéma électrique général d'un circuit intégré modifié selon l'invention;
- la figure 2 représente un dispositif d'isolation d'un substrat P selon l'invention utilisant une diode D2;
- la figure 3 est la courbe courant-tension aux bornes de la diode D2 du dispositif de la figure 2;
- la figure 4 représente les courbes courant-tension respectives de deux pattes de connexion protégées selon l'invention et la courbe courant-tension résultante entre ces deux pattes;

2

- la figure 5 représente un dispositif de protection d'une patte de connexion à une tension d'alimentation externe selon l'invention;
- la figure 6 représente la courbe courant-tension de la patte de connexion à la tension d'alimentation externe du dispositif de la figure 5;
- les figures 7a et 7b représentent une réalisation en diffusion d'une résistance de limitation de courant utilisée dans l'invention respectivement, en vue de dessus et en coupe AA;
- la figure 8 représente un dispositif de protection d'un transistor N de sortie pour un substrat semi-conducteur P selon l'invention;
- la figure 9 est la courbe courant-tension du transistor N de sortie du dispositif de la figure 8;
- la figure 10 représente un dispositif de protection d'un transistor P de sortie pour un substrat semi-conducteur P selon l'invention;
- la figure 11 est la courbe courant-tension du transistor P de sortie du dispositif de la figure 10;
- la figure 12 représente un dispositif de protection de la grille d'entrée d'un inverseur CMOS selon l'invention;
- la figure 13 est la courbe courant-tension à l'entrée de l'inverseur CMOS du dispositif de la figure 12;
- la figure 14 montre une réalisation particulière d'un transistor bipolaire latéral de protection contre les décharges électrostatiques selon l'invention;
- la figure 15 représente une caractéristique courant-tension du transistor bipolaire latéral de la figure 14.

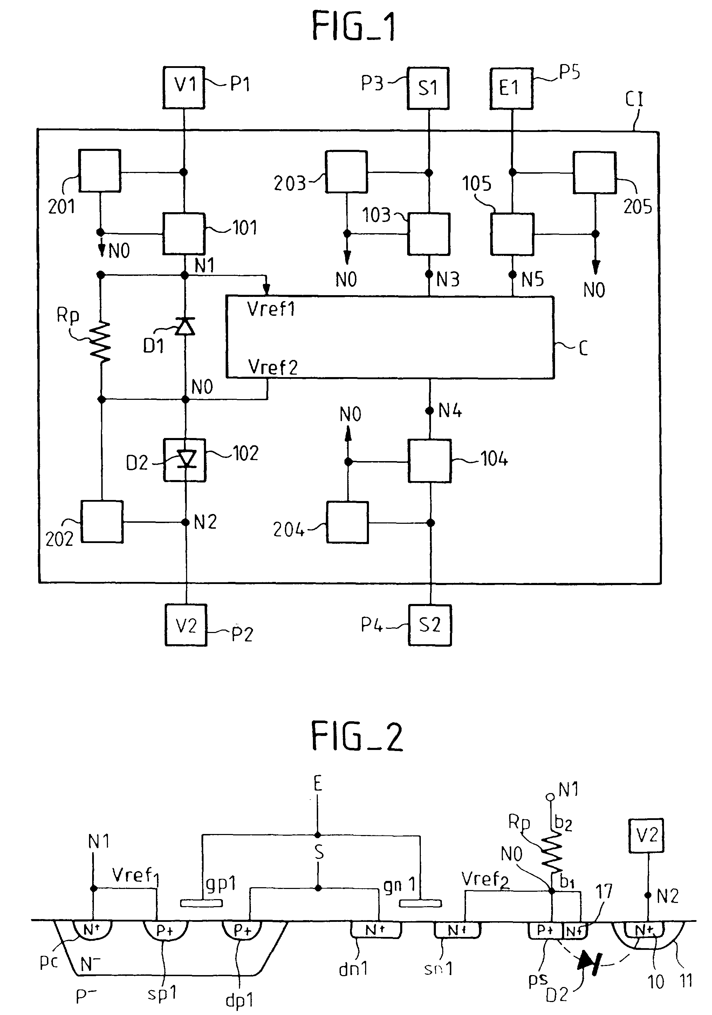

La figure 1 représente un circuit intégré CI auto-protégé selon l'invention. Le circuit intégré comporte des pattes de connexion P1, P2, P3, P4, P5 de noeuds électriques internes N1, N2, N3, N4, N5 à des signaux externes V1, V2, S1, S2, E1.

Le signal externe V1 est fourni par une première source d'alimentation externe non représentée sur la figure. Le signal externe V2 est fourni par une deuxième source d'alimentation externe non représentée sur la figure.

Dans la suite on identifie la patte de connexion au signal externe associé. Ainsi V1 désigne indifféremment la patte de connexion et le signal externe d'alimentation.

Entre le noeud électrique interne N1 et un noeud interne N0, on a une diode D1. Entre le noeud interne N0 et le noeud électrique interne N2, on a une diode D2. Les diodes D1 et D2 sont montées en opposition entre les noeuds électriques internes N1 et N2 : en polarisation normale V1, V2, la diode D1 est bloquée et la diode D2 est passante; en polarisation inverse, c'est le contraire. Dans l'exemple retenu dans la suite d'un circuit à substrat P où V1 est une tension positive de l'ordre de 5 volts et V2 est la tension nulle, on a donc la cathode de la diode D1 qui est reliée au noeud électrique interne N1 associé à V1 et la cathode de la diode D2 qui est reliée au noeud électrique interne N2 associé à V2 et les anodes des diodes D1 et D2 qui sont reliées ensemble au noeud interne N0. Dans l'exemple non retenu dans la suite d'un circuit à substrat P où c'est V2 la tension positive de l'ordre de 5 volts et V1 la tension nulle, on a donc l'anode de la diode D1 qui est reliée au noeud électrique interne N1 associé à V1 et l'anode de la diode D2 qui est reliée au noeud électrique interne N2 associé à V2 et les cathodes des diodes D1 et D2 qui sont reliées ensemble au noeud interne N0.

Une résistance de polarisation Rp est placée en parallèle sur la diode D1, entre les noeuds N1 et N0.

Le noeud N1 fournit une première tension de référence interne Vref1 à la circuiterie C du circuit intégré.

Le noeud N0 fournit une deuxième tension de référence interne Vref2 à la circuiterie C du circuit intégré et polarise le substrat à cette tension Vref2. Par la suite pour désigner le noeud N0 on parlera de noeud du substrat N0. La tension au noeud du substrat N0 sera notée VN0 égale à Vref2. La circuiterie reçoit ses autres signaux d'entrées-sortie S1, S2, E1 des noeuds électriques internes N3, N4, N5 associés aux autres pattes de connexion P3, P4 et P5.

Entre chaque patte de connexion Pi et le noeud électrique interne associé Ni, il y a un dispositif de protection contre les surtensions 10i connecté au noeud électrique du substrat N0. En parallèle entre chaque patte de connexion Pi et le noeud du substrat N0, il y a un dispositif de protection contre les décharges électrostatiques 20i (i∈[1,5]). Les caractéristiques de ces dispositifs de protection sont détaillées plus loin.

Dans un circuit intégré classique, la caractéristique courant-tension entre V1 et le substrat semi-conducteur court-circuité à V2 correspond à celle d'une diode D1 (figure 1) inhérente à la structure du circuit. Cette diode a typiquement une tension directe de l'ordre de 0,6 volts et une tension inverse de l'ordre de 15 à 20 volts, selon les caractéristiques de fabrication du circuit intégré.

La diode D1 inhérente à la structure du circuit est bloquée en polarisation normale du circuit intégré, et passe en direct en polarisation inverse du circuit intégré (inversion des tensions V1 et V2). Comme par ailleurs le substrat semi-conducteur d'un circuit intégré est classiquement court-circuité à V2 par une prise de substrat, si une inversion de polarité se produit entre V1 et V2, et si cette tension inverse entre V1 et V2 est supérieure au seuil en direct (0,6 volts) de la diode D1, cette dernière passe en direct et appelle un fort courant entre V1 et V2 qui détruit le circuit intégré (court-circuit entre V1 et V2).

Dans l'invention (figure 1), on place entre le substrat et la tension externe V2 une diode D2 faiblement polarisée en direct en polarisation normale du circuit. Dans l'exemple représenté, la polarisation de la diode D2 est assurée par la

EP 0 551 038 B1

résistance de polarisation Rp placée entre le noeud N1 et le noeud du substrat N0 et donc montée en parallèle sur la diode parasite D1. Cette résistance de polarisation impose au noeud du substrat N0 une tension proche de la deuxième tension de référence externe V2 utilisée habituellement pour polariser le substrat.

Dans l'invention cette tension de polarisation au noeud du substrat N0 est utilisée comme deuxième tension de référence interne Vref2 de la circuiterie C du circuit intégré : cette deuxième tension de référence interne Vref2 est donc décalée d'environ 0,6 volts (seuil en direct de la diode) par rapport à la deuxième tension de référence externe V2 utilisée dans l'art antérieur comme deuxième tension de référence interne et comme tension de polarisation du substrat.

Dans la suite, on prend l'exemple d'un circuit intégré fabriqué en technologie CMOS à substrat P⁻. C'est un exemple non restrictif qui se transpose aisément dans les autres technologies (CMOS substrat N⁻, NMOS, PMOS, bipolaire ou mélange de ces technologies). Dans cet exemple, la première tension de référence externe V1 est une tension positive Vcc et la deuxième tension de référence externe V2 est une tension négative Vss. Dans ces conditions, la deuxième tension de référence interne Vref2 est de l'ordre de 0,6 volt.

La figure 2 représente le schéma d'un inverseur CMOS avec un dispositif de protection 102 du substrat selon l'invention. L'inverseur CMOS classique est formé d'un transistor de type P Tp1 avec une grille gp1, une source sp1 et un drain dp1 et d'un transistor de type N Tn1 avec une grille gn1, une source sn1 et un drain dn1. Le transistor P noté Tp1 est réalisé dans un caisson N⁻, le transistor N noté Tn1 est réalisé dans le substrat P⁻. Les grilles gp1 et gn1 des transistor Tp1 et Tn1, sont reliées ensemble et forment l'entrée E de l'inverseur. Les drains dp1 et dn1 des transistors Tp1 et Tn1 sont reliés ensemble et forment la sortie S de l'inverseur.

La source sn1 du transistor Tn1 est connectée à la deuxième tension de référence interne Vref2. Une prise de substrat ps (diffusion P⁺ réalisée dans le substrat P⁻) connecte par ailleurs le substrat P⁻ à cette deuxième tension de référence interne. La deuxième tension de référence interne est délivrée par une borne b1 de la résistance de polarisation Rp connectée par son autre borne b2 à la première tension de référence interne Vref1.

La source sp1 du transistor Tp1 est reliée au noeud électrique interne N1 associé à la tension externe V1. Le noeud N1 est par ailleurs relié au caisson N⁻ par une prise de caisson pc (diffusion N⁺ dans le caisson N⁻).

La diode d'isolation D2 du dispositif de protection 102 est réalisée par une diffusion N⁺ 10 et le substrat P⁻. La diffusion N⁺ 10 est contactée au noeud électrique interne N2 associé à la tension externe V2. Une telle diode a une tension de seuil de l'ordre de 0,6 volt en direct et entre 15 et 20 volts en inverse.

De préférence, et comme représenté sur la figure 2, on réalise la diode D2 en technologie CMOS à caisson avec la diffusion N⁺ 10 baignant entièrement dans un caisson N⁻ 11 (le signe + ou - indiquant une concentration d'impuretés de dopage plus importante ou moins importante). On obtient ainsi un seuil de tension inverse de diode d'une centaine de volts.

Avec le dispositif d'isolation du substrat selon l'invention, en cas d'inversion de polarité, la diode D1 passe en direct comme dans l'art antérieur, mais la diode d'isolation D2 devient bloquée. Pour une tension négative entre V1 et V2 inférieure au seuil de tension inverse de la diode D2, il n'y a plus de passage de courant entre V1 et V2. L'incursion de tension négative admissible sur V1 est cependant limitée par le seuil de tension inverse de la diode D2 : 15 à 20 volts avec une technologie de diode classique, 100 volts en technologie CMOS à caisson. Au delà du seuil de tension inverse, la diode D2 conduit par avalanche.

Une diffusion N⁺ 17 complémentaire connectée au noeud N0 est représentée sur la figure 2, placée entre la prise de substrat et le caisson N⁻ 11. L'utilité de cette diffusion sera décrite plus loin.

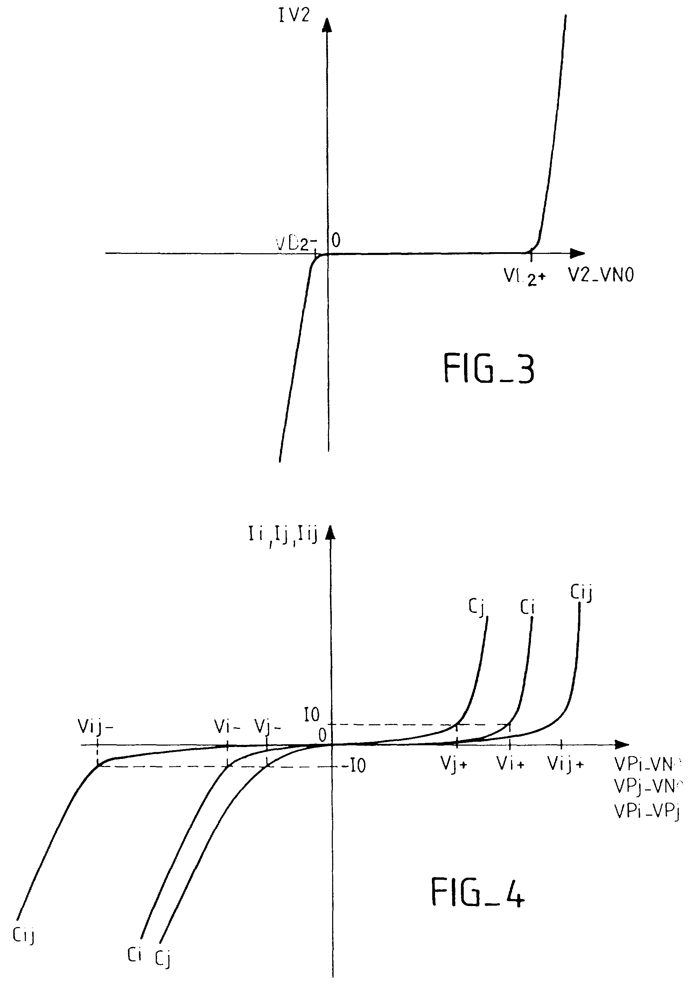

La caractéristique courant-tension représentée en figure 3 est celle de la patte P2 de connexion à V2 par rapport au noeud du substrat N0. C'est donc la courbe courant-tension aux bornes de la diode D2. Dans l'exemple d'une diode D2 en technologie CMOS à caisson, son seuil en direct est de 0,6 volt et son seuil en inverse est de la centaine de volts. La courbe donne le courant en fonction de la tension V2-VN0. C'est pourquoi le seuil en direct est noté en négatif (VD2- = -0,6 volt) et le seuil en inverse est noté en positif (VD2+ = 100 volts). Entre -0,6 volt et 100 volts, le courant de diode est pratiquement nul (circuit ouvert). Au-delà des deux seuils en valeur absolue, le courant croît très fortement, notamment au delà du seuil de tension inverse VD2+ avec la mise en avalanche de la diode D2. On préférera donc utiliser la diode D2 en technologie CMOS à caisson qui a un seuil de tension inverse élevé. En contrepartie ce choix peut nécessiter un niveau d'implantation supplémentaire pour la réalisation du caisson de la diode (D2), par exemple pour un circuit intégré en technologie NMOS, ce qui va augmenter les coûts de fabrication. On pourra alors préférer dans certains cas une technologie classique N⁺/P⁻.

Dans l'invention, on a donc isolé le substrat de la patte de connexion à V2 par la diode D2 polarisée en direct en fonctionnement normal. Ceci résout efficacement le problème d'inversion de polarité d'une part et permet d'isoler le substrat en interne d'autre part. Dans l'invention on place avantageusement un dispositif de protection 101,...,105 entre chacune des pattes de connexion V1, V2, S1, S2 et E1 et le noeud du substrat N0 (figure 1) pour modifier la caractéristique courant-tension de chacune des pattes de connexion par rapport au noeud commun N0. Avec chacun des dispositifs de protection, on va en effet obtenir pour la patte de connexion associée, une caractéristique courant-tension par rapport au noeud du substrat N0 ayant l'allure représentée en figure 4 : pour une tension VPi-VN0 entre la patte de connexion Pi et le noeud du substrat N0 comprise entre un seuil négatif Vi- et un seuil positif Vi+, le courant IPi est compris entre un courant limite -I0 et +I0 de faible valeur. Ce courant limite I0 est déterminé pour un circuit intégré donné, comme la plus petite valeur du courant maximum acceptable Imax dans une patte de connexion Pi sur l'ensemble des n pattes de connexion du circuit intégré.

$$I0 = Inf \ Imax \quad i \in [1,n]$$
$$i$$

En pratique, I0 a une valeur d'une dizaine de milliampères, par exemple 10 milliampères.

On va montrer qu'avec une telle structure de l'invention, on va obtenir une protection générale du circuit intégré contre les surtensions ou autres phénomènes destructeurs. Soient donc deux pattes de connexion Pi, Pj pour lesquelles on a une telle caractéristique courant-tension associée $c_i$, $c_j$ (figure 4). La caractéristique $c_i$ est définie pour le courant limite I0 avec un seuil négatif Vi- et un seuil positif Vi+ par rapport au noeud commun N0. La caractéristique $c_j$ est définie pour le courant limite I0 avec un seuil positif Vj- et un seuil négatif Vj+ par rapport au noeud commun N0.

La caractéristique résultante $c_{ij}$ entre la patte de connexion Pi et la patte de connexion Pj se déduit alors aisément de la relation suivante :

$$Vi-Vj = (Vi-VN0) - (Vj-VN0)$$

Ainsi pour une tension comprise entre un seuil négatif Vij- donné par la relation (1):

$$Vij- = Vi- - Vj+ \tag{1}$$

et un seuil positif Vij+ donné par la relation (2):

$$Vij+ = Vi+ - Vj- \tag{2}$$

le courant passant dans la patte de connexion Pi ou Pj sera inférieur au courant limite I0.

Si on généralise ce raisonnement à l'ensemble des pattes de connexion du circuit intégré, avec pour chacune une caractéristique courant-tension ayant l'allure représentée en figure 4, il existe alors une valeur de tension VM inférieure en valeur absolue à toutes les valeurs Vij+ ou Vij- possibles, donnée par la relation (3):

$$VM = Inf \ (Vij+, \ Vij-) \qquad (3)$$
$$i,j$$

Cette valeur de tension VM est telle que, appliquée entre deux pattes de connexion quelconque du circuit intégré, le courant dans chacune des deux pattes de connexion sera inférieur en valeur absolue au courant limite I0. Ainsi, en utilisant le substrat isolé selon l'invention comme noeud commun N0 à toutes les pattes de protection et en plaçant un dispositif de protection $10_i$ entre chacune des pattes de connexion Pi et le substrat, on obtient bien une protection générale du circuit intégré. Dans l'invention, on cherche à rendre VM le plus grand possible de l'ordre de la centaine de volts. Il faudrait donc obtenir pour chaque patte de connexion Pi que les seuils positif Vi+ et négatif Vi- soient le plus grand possible.

Or des relation (1), (2) et (3) il vient que si on agit sur un seul des paramètres des relations (1) et (2), le même dans chacune des relation (1) et (2) par exemple le seuil positif Vi+, Vj+, de façon à obtenir ce paramètre Vi+, Vj+ de l'ordre de 100 volts, pour chaque paire possible de pattes de connexion, les seuils négatifs Vij- et positif Vij+ donnés par la relation (3) seront au moins de l'ordre de 100 volts, même si les seuils négatifs Vi-, Vj- des pattes de connexion ne sont que de -0,6 volt.

Dans l'invention, on propose donc avantageusement de placer un dispositif de protection contre les surtensions positives entre chaque patte de connexion et le noeud du substrat N0. La structure obtenue permettra une protection générale contre les surtensions positives et négatives. En effet, si une surtension négative se présente sur une patte de connexion Pi, il y aura une autre patte de connexion Pj pour laquelle cette surtension apparaîtra comme positive par rapport au noeud du substrat N0 et le dispositif de protection $10_j$ associé pourra limiter le courant appelé. Il y a plusieurs mode de réalisation possible avec des dispositifs de protection contre soit les surtensions positives seulement, soit les surtensions négatives seulement ou encore avec des dispositifs mixtes. Dans la suite on décrit un mode de réalisation préférée avec des dispositifs de protection des pattes de connexion contre les surtensions positives jusqu'à une centaine de volts.

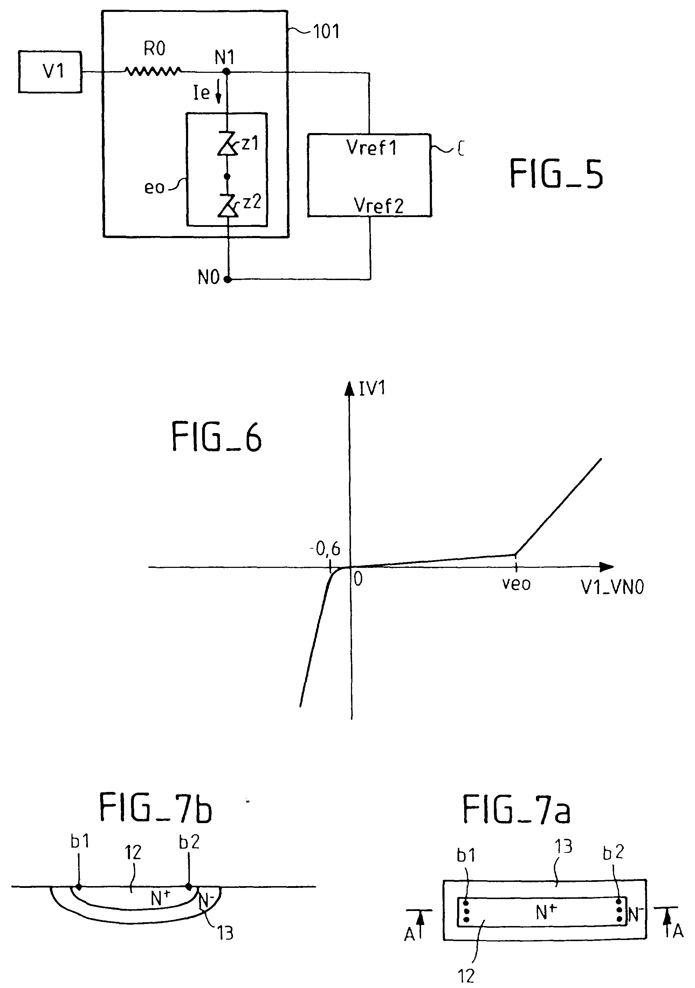

La figure 5 représente un exemple d'un dispositif de protection $10_1$ de la patte de connexion à une source d'alimentation externe, comprenant un écrêteur de tension $e_0$ et une résistance de limitation du courant R0.

L'écrêteur de tension $e_0$ est placé entre le noeud N1 associé à V1 et le noeud du substrat N0. En aval de l'écrêteur, entre le noeud N1 et le noeud de substrat N0, on a la circuiterie interne C du circuit intégré, qui reçoit la première tension de référence interne Vref1 du noeud N1 et la deuxième tension de référence Vref2 du noeud N0. L'écrêteur a un seuil de déclenchement $ve_0$ inférieur au seuil en inverse de la diode D1 (10-15 volts). Ce seuil de déclenchement $ve_0$ vaut par exemple 12 volts. Ainsi, en cas de surtension positive par rapport à N0, l'écrêteur $e_0$ se déclenche avant la diode D1 et il absorbe tout le courant Ie. L'écrêteur $e_0$ est réalisé dans l'exemple de la figure 5 au moyen de diodes zener $z_1$ et $z_2$ en série et en inverse, réalisées selon le procédé CMOS décrit dans le brevet italien n° 2 222 8 A/89 déposé au nom de Sgs-Thomson Microelectronics s.r.l. le 31 octobre 1989, aussi bien que la demande de brevet européenne n° 90/202840.6 (EP-A-426241) correspondante. D'autres réalisations sont possibles, par exemple avec des transistors montés en diode.

La résistance de limitation R0 est placée entre V1 et le noeud interne N1 associé pour limiter le courant le passant dans l'écrêteur e0 à des valeurs non destructives pour l'écrêteur e0. La valeur de cette résistance de limitation doit être suffisamment faible pour ne pas provoquer une chute de tension sur la première tension de référence interne Vref1 puisque l'on a alors Vref1 = V1 -(R0 x lst), où lst est la consommation du circuit intégré sur V1 en fonctionnement normal. La valeur de la résistance de limitation doit aussi être suffisamment élevée pour limiter suffisamment le courant le dans l'écrêteur e0. En pratique, si on note lcrit le courant limite acceptable dans l'écrêteur, si on recherche une protection aux surtensions par exemple jusqu'à VM, le seuil de déclenchement de l'écrêteur e0 étant noté ve0, on prendra R0 tel que :

$$\mathrm{lcrit} = \frac{\mathrm{VM - ve0}}{\mathrm{R0}}$$

Ainsi, jusqu'à VM volts, l'écrêteur e0 sera capable d'absorber tout le courant appelé et le circuit intégré ne sera pas endommagé. Dans un exemple avec VM égal à 100 volts, ve0 égal à 12 volts et pour un courant critique lcrit de 440 milliampères, R0 vaut 200 ohms. Si le circuit consomme 1 milliampère sur V1 en fonctionnement normal, la chute de tension dans la résistance de limitation R0 est de 200 millivolts, ce qui est acceptable.

D'une manière générale, les paramètres des différents éléments du dispositif de protection 101 sont bien connus (écrêteur, résistance) et sont calculés ou choisis selon les méthodes connues des hommes de métier. La résistance R0 peut être réalisée en polysilicium ou par une diffusion $N^+$.

Dans un exemple préféré représenté en figures 7a et 7b, la résistance de limitation R0 est une diffusion $N^+$ 12 entièrement réalisée dans un caisson $N^-$13. Les bornes de contact b1 et b2 sont prises en bord de caisson chacune à une extrémité opposée de la diffusion 11. En effet, si la résistance de limitation est une simple diffusion $N^+$ du type drain d'un transistor de type N, on crée une diode parasite $N^+/P^-$ avec le substrat avec un seuil inverse entre 15 et 20 volts. L'écrêteur e0 ne servirait alors plus à rien puisque, la diode parasite de la résistance passerait en avalanche entre 10 et 15 volts et la tension aux bornes de l'écrêteur ne pourrait jamais dépasser cette tension d'avalanche.

La caractéristique courant-tension résultante entre la patte de connexion à V1 et le noeud du substrat N0 est représentée sur la figure 6. Pour une tension négative par rapport à la tension VN0 du noeud du substrat, il y aura toujours une jonction PN à passer en direct (du type de la diode D1). Cette jonction PN écrête typiquement la tension V1-VN0 à - 0,6 volts. Pour une tension appliquée sur V1 positive par rapport à la tension VN0 du noeud du substrat N0, le courant IV1 appelé sur V1 croît faiblement entre 0 volt et la tension de seuil de déclenchement ve0 de l'écrêteur. Cette partie de la caractéristique correspond à la consommation statique du circuit intégré sur le V1. L'écrêteur se déclenche pour une tension positive V1-VN0 supérieure à Ve0 de l'ordre de 12 volts, avant que les diodes parasites du type de la diode D1 (figures 1, 2) ne passent en avalanche. L'écrêteur déclenché absorbe tout le courant. La caractéristique courant-tension a une pente inversement proportionnelle à la résistance de limitation R0 du courant : quand l'écrêteur est déclenché, le circuit équivalent entre V1 et N0 consiste en la résistance de limitation R0 du courant en série avec un générateur de tension ve0.

Un tel dispositif de protection 101 qui s'applique à la tension V1 positive (Vcc), s'applique aussi à toute autre tension positive externe. Si la tension V1 était négative, par exemple pour un circuit intégré à substrat $N^-$, le dispositif de protection 101 s'appliquerait aux autres tensions négatives externes. Dans l'art antérieur, en cas de surtension positive sur V1, la diode D1 entre V1 et V2 et inhérente à toute structure de circuit intégré passe en avalanche au delà de 15 à 20 volts et le très fort courant appelé va détruire le circuit en provoquant un court-circuit entre V1 et V2.

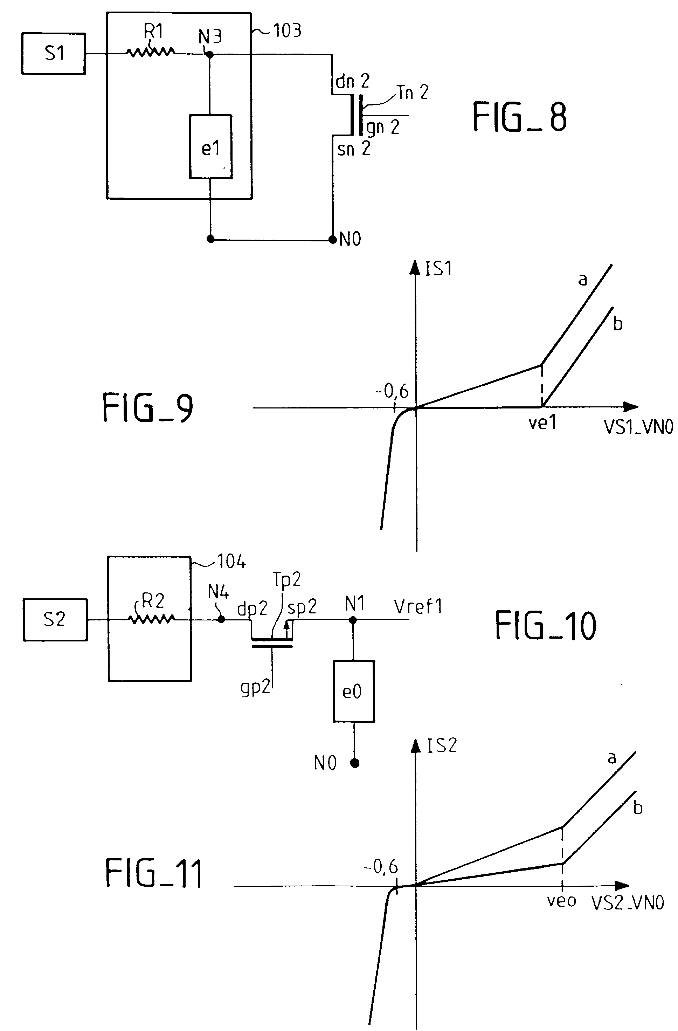

La figure 8 représente un dispositif de protection 103 d'un drain dn2, d'un transistor N Tn2 monté en sortie à drain ouvert : le drain dn2 est connecté par exemple à la patte de connexion S1 (figure 1), la grille gn2 du transistor Tn2 est commandée par un élément de circuit interne non représenté, et la source sn2 est connectée au noeud du substrat N0. Dans cet exemple (figure 8), le même type de dispositif de protection avec un écrêteur de tension e1 et une résistance R1 de limitation du courant est proposé. Pour une surtension positive, la diode drain-substrat du transistor Tn2 risque en effet de passer en avalanche vers 15 - 20 volts : on retrouve le même problème déjà vu pour la tension de référence externe V1. On propose donc une solution identique.

La résistance R1 est connectée entre S1 et le noeud électrique interne N3 associé, l'écrêteur de tension e1 est connecté en parallèle sur le transistor Tn2 entre le noeud N3 et le noeud du substrat N0. Les caractéristiques propres du dispositif de protection 103 (valeur de R1 par exemple) vont dépendre des caractéristiques de l'étage de sortie. Par exemple s'il a une faible impédance de sortie, R1 devra être aussi faible que possible.

La courbe caractéristique courant-tension de la patte de connexion S1 par rapport au noeud du substrat N0 avec le dispositif de protection selon l'invention est représentée sur la figure 9. Deux caractéristiques courant-tension a et b sont obtenues avec le dispositif de protection selon que le transistor Tn2 de sortie est passant (tension positive commandée sur gn2) ou non. Pour une tension VS1-VN0 comprise entre 0 et le seuil de déclenchement vel de l'écrêteur (environ 12 volts), si le transistor Tn2 de sortie est passant (caractéristique a) il est équivalent à une résistance RON. Le circuit équivalent vu de S1 entre S1 et N0, correspond donc à la résistance de limitation du courant R1 en série avec la résistance équivalente RON du transistor Tn2, soit à une résistance globale Req1=R1+RON. La caractéristique courant-tension a donc une pente égale à 1/Req1. Au delà du seuil de déclenchement ve1 de l'écrêteur, celui-ci se déclenche et absorbe tout le courant : le courant passant dans le transistor Tn2 est alors limité à Ve1/RON et le circuit équivalent se réduit à la résistance de limitation du courant R1 en série avec un générateur de tension ve1. Au delà du seuil de déclenchement ve1, la caractéristique courant-tension a donc une pente égale à 1/R1.

Si le transistor Tn2 est bloqué (caractéristique b), il est équivalent à un circuit ouvert tant que le seuil inverse de la diode drain-substrat n'est pas atteint. Pour une tension VS1-VN0 inférieure au seuil de déclenchement vel, l'écrêteur e1 étant lui aussi bloqué, il n'y a aucun courant : le circuit équivalent entre S1 et N0 est un circuit ouvert : la caractéristique courant-tension a une pente nulle. Au delà de ve1, l'écrêteur e1 se déclenche et le circuit équivalent entre S1 et N0 est la résistance de limitation du courant R1 en série avec un générateur de tension ve1. La caractéristique courant-tension à partir de la tension VS1-VN0 égale à vel a une pente égale à 1/R1.

La figure 10 représente un dispositif de protection 104 du drain dp2 d'un transistor P Tp2 monté en sortie à drain ouvert, comprenant une résistance de limitation du courant R2.

Le drain dp2 du transistor Tp2 est connecté par exemple à la patte de connexion S2 de la figure 1, au noeud interne N4 associé. La source sp2 du transistor Tp2 est connectée au noeud N1 à la tension de référence interne positive Vref1. La grille gp2 du transistor Tp2 est commandée par un élément de circuit interne non représenté. Le caisson $N^-$ dans lequel est réalisé le transistor Tp2 (technologie CMOS substrat $P^-$) est connecté par une prise de caisson au noeud N1 à la première tension de référence interne Vref1. Cette connexion de prise de caisson est matérialisée sur la figure par une flèche sortante (canal P) perpendiculaire à la barre représentant le canal source-drain du transistor, la pointe de la flèche étant rattachée à la source sp2.

On retrouve entre le noeud N1 et le noeud du substrat N0 l'écrêteur de tension e0 associé à la patte de connexion à V1 selon l'invention.

La résistance de limitation R2 du courant dans la patte de connexion à S2 est placée en série entre S2 et le noeud interne N4 associé.

Quand la tension VS2-VN0 est positive, la jonction drain-caisson du transistor Tp2 passe en direct à partir de 0,6 volt environ. Le caisson est par ailleurs connecté à l'écrêteur e0 associé à V1. Donc, au-delà de 0,6 volt, la tension imposée par la patte de connexion S2 au noeud N1 de l'écrêteur e0 est diminuée de la chute de tension dans la résistance de limitation R2 et de la chute de tension de 0,6 volt dans la jonction drain-caisson du transistor Tp2. On se retrouve pratiquement dans le cas de la figure 5, pour la protection associée à V1.

Dans un exemple préféré de réalisation, on n'utilise donc pas d'écrêteur de tension particulier au drain dp2 du transistor P de sortie Tp2 à drain ouvert, mais avantageusement l'écrêteur de tension e0 associé à la tension V1 qui polarise le caisson de ce transistor de sortie Tp2.

Les caractéristiques statiques a,b (circuit non alimenté) en courant-tension du dispositif de la figure 10 sont représentées sur la figure 11. Elles correspondent à celle de la figure 9 pour le transistor N, passant (a) ou bloqué (b) avec en plus la consommation statique sur V1 qui s'ajoute dans les deux cas (a) et (b) tant que la tension VS2-VN0 est inférieure au seuil de déclenchement ve0 de l'écrêteur e0. Au delà du seuil ve0, les deux caractéristiques ont une pente égale à 1/R2.

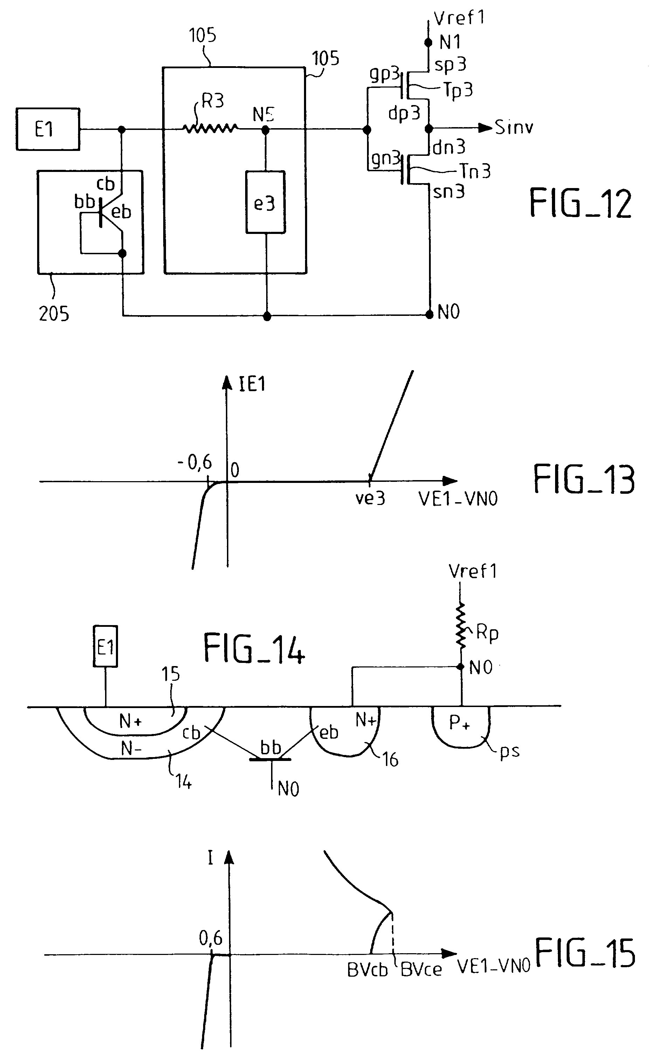

La figure 12 représente un dispositif de protection 105 d'un étage d'entrée à inverseur CMOS, comprenant un écrêteur de tension e3 et une résistance R3 de limitation du courant.

L'inverseur CMOS est formé de manière connue d'un transistor P Tp3 et d'un transistor N Tn3. Leurs drains dp3 et dn3 sont connectés ensemble à la sortie Sinv de l'inverseur. Leurs grilles gp3 et gn3 sont connectées ensemble à la patte de connexion E1 au noeud N5 de la figure 1. Leurs sources sp3 et sn3 sont respectivement connectées à la première tension de référence interne Vref1 au noeud N1 et à la deuxième tension de référence interne Vref2 au noeud du substrat N0.

La résistance R3 de limitation du courant est placée entre la patte de connexion E1 et le noeud N5 et l'écrêteur de tension e3 est connecté entre le noeud N5 et le noeud du substrat N0.

En cas de surtensions positives, le problème bien connu qui se pose est le claquage diélectrique de l'oxyde de grille entre la grille et le canal du transistor, claquage provoqué par une tension entre la grille et le substrat supérieure à une tension de claquage d'oxyde de grille typiquement de l'ordre de 50 volts. Le seuil de déclenchement ve3 de l'écrêteur e3 doit donc être inférieur à 50 volts, et la résistance R3 calculée en conséquence selon des critères déjà vus précédemment. La caractéristique courant-tension du dispositif de la figure 12 est représentée sur la figure 13. Tant que la tension VE1-VN0 est comprise entre 0 volt et le seuil de déclenchement ve3 de l'écrêteur e3, il n'y a aucun courant appelé sur la patte de connexion E1. La caractéristique courant-tension a une pente nulle. Au-delà de la tension ve3, l'écrêteur e3 se déclenche. La caractéristique courant-tension a une pente égale à 1/R3.

On vient donc de voir un certain nombre de cas pratiques mettant en oeuvre le principe de l'invention à savoir obtenir une caractéristique large de protection pour chacune des pattes de connexion du circuit intégré par rapport au substrat qui forme un noeud interne commun pour ces pattes de connexion, le substrat étant isolé de la tension de référence externe à laquelle il est habituellement court-circuité. Ces cas pratiques ne sont pas limitatifs et ne sont que des exemples d'application du principe de l'invention, exemples qui pourront être combinés entre eux. Par exemple pour la sortie d'un inverseur CMOS on utilisera les exemples vus en figure 8 et 10.

L'invention permet de résoudre avantageusement le problème d'inversion des polarités, et des surtensions positives ou négatives d'une centaine de volts appliquées de manière quasi permanentes (plusieurs secondes ou minutes).

La structure de l'invention offre aussi une protection efficace contre les déclenchements de thyristors parasites du circuit intégré provoqués par des appels de courant trop forts et qui entraînent la destruction du circuit intégré ; (c'est le phénomène de verrouillage, "latch-up" en littérature anglo-saxonne). En effet, la structure proposée permet de supprimer les causes du déclenchement des thyristors et ses effets :

- Il supprime les causes, car avec les dispositifs de protection selon l'invention, le courant appelé sur n'importe quelle patte de connexion reste toujours inférieur à un courant limite I0 de l'ordre de 10 milliampères pour une tension inférieure à une centaine de volts. Cette limitation de courant est suffisamment forte pour empêcher le déclenchement d'un thyristor.

Dans l'art antérieur, il existait toujours une diode en direct entre une patte de connexion et une tension de référence interne, pouvant laisser passer un fort courant : un verrouillage était alors toujours possible.

- Il supprime les effets, car le courant sur les pattes de connexion des tensions V1 et V2 est toujours limité dans l'invention par les résistances de limitation de courant R0, R1... Il n'y a donc plus de court-circuit possible entre V1 et V2 comme dans l'art antérieur. De manière générale, la structure d'un circuit intégré modifié selon l'invention permet de protéger le circuit contre des courants élevés qui peuvent être forcés sur les pattes de connexion du circuit intégré dans une intention frauduleuse, pour fausser par exemple le fonctionnement d'une mémoire. Ces problèmes de fraude concernent tout particulièrement les cartes bancaires. L'isolation du substrat et les dispositifs de protection placés entre chacune des pattes de connexion et ce substrat isolé permettent de réduire à néant ces agissements.

Cependant les dispositifs de protection décrits précédemment ne permettent pas de protéger le circuit intégré contre des surtensions très élevées mais très brèves : les décharges électrostatiques, par exemple (typiquement 2 kilovolts sur 1 microseconde). Ils permettent seulement de protéger contre les surtensions de longue durée, "permanentes".

On rajoute donc un dispositif de protection aux décharges électrostatiques 201 à 205 entre chacune des pattes de connexion et le noeud du substrat N0, en amont du dispositif de protection associé (figure 1). Un tel dispositif 205 est représenté sur la figure 12. Il est placé entre la patte de connexion E1 et le substrat, en amont de la résistance de limitation R3 et de l'écrêteur e3 du dispositif de protection 105 contre les surtensions associé.

Dans un exemple représenté sur la figure 12, le dispositif de protection contre les décharges électrostatiques est un transistor bipolaire latéral, de type NPN pour un substrat de type P$^-$, dont le collecteur cb est connecté à la patte de connexion E1 et dont l'émetteur eb et la base bb sont connectés au noeud du substrat N0.

Dans l'invention, on propose une réalisation particulière de ce transistor bipolaire latéral, de manière à ce qu'il se déclenche pour un seuil de l'ordre de 100 volts. Ainsi, il ne gêne pas le fonctionnement du dispositif de protection aux surcharges permanentes, et au contraire prend son relais efficacement à partir de 100 volts pour la protection aux décharges électrostatiques. Cette réalisation particulière est montrée sur la figure 13. L'émetteur eb du transistor est une diffusion N$^+$ 16 reliée au noeud N0 du substrat. Le collecteur cb du transistor connecté à la patte de connexion E1 est une diffusion N$^+$ 15 baignant intégralement dans un caisson N$^-$ 14. L'émetteur et le collecteur sont en vis à vis et la bande de substrat P$^-$ qui sépare le caisson 14 de l'émetteur eb forme la base bb de ce transistor.

Pour une tension VE1-VN0 négative, la diode caisson N$^-$/substrat P$^-$ passe en direct à partir de -0,6 volts. Pour une tension VE1-VN0 positive, la diode caisson N$^-$/substrat P$^-$ passe en avalanche vers 100 volts : la conduction se fait alors par claquage collecteur base BVcb (Breakdown Voltage collector-base) suivi d'un claquage collecteur émetteur BVce (Breakdown Voltage collector-emittor) : la caractéristique courant-tension typique de ce transistor bipolaire latéral est représentée sur la figure 15.

La réalisation particulière montrée sur la figure 13 consiste en la réalisation de la diffusion connectée à la patte à protéger entièrement dans un caisson et non partiellement dans un caisson ou directement dans le substrat, ce qui permet d'obtenir des tensions de claquage de l'ordre de 100 volts.

Avec le dispositif de protection contre les décharges électrostatiques ajouté en complément à la structure proposée dans l'invention du circuit intégré, on obtient une protection générale du circuit intégré vis à vis de tous les phénomènes externes destructeurs possibles. Dans le cas de la protection de la patte de connexion V2, (figure 2), on réalise le transistor bipolaire latéral en rajoutant une diffusion N$^+$ 17 connectée au noeud du substrat N0 entre la prise de substrat ps et le caisson N$^-$ 11 : le transistor bipolaire latéral ainsi formé dans la structure même de la diode et en parallèle sur la diode D2 protège cette dernière des décharges électrostatiques.

En pratique, on pourra avoir un seul dispositif de protection global pour plusieurs pattes du même type (ayant les mêmes contraintes) par exemple les entrées sur les grilles d'inverseur CMOS, et comportant un seul dispositif de protection contre les surcharges électrostatiques et un seul dispositif de protection contre les surtensions.

**Revendications**

1. Circuit intégré réalisé à partir d'un substrat semi-conducteur d'un premier type de dopage, comportant des pattes de connexion (P1,...,P5) de noeuds fonctionnels internes (N1,...,N5) à des signaux externes (V1,V2,S1,S2,E1), le circuit intégré disposant d'une première référence de tension interne (Vref1) délivrée par une patte de connexion (P1) à une première source de tension externe (V1), le substrat semi-conducteur étant polarisé à une deuxième référence de tension interne (Vref2), caractérisé en ce qu'il comprend un dispositif de protection (101,...,105) contre les surtensions entre chacune des pattes de connexion (P1,...,P5) et le substrat semi-conducteur, une diode (D2) connectée entre le substrat semi-conducteur et une patte de connexion (P2) à une deuxième source de tension de référence externe (V2), et une résistance de polarisation (RP) connectée entre la première (Vref1) et la deuxième (Vref2) référence de tension interne, en sorte que la diode (D2) est polarisée en direct en polarisation normale du circuit intégré et en inverse en polarisation inversée du circuit intégré, pour isoler le substrat semi-conducteur de la patte de connexion (P2) à la deuxième source de tension externe à laquelle il est habituellement court-circuité.

2. Circuit intégré selon la revendication 1, caractérisé en ce qu'un dispositif de protection (101) contre les surtensions associé à une patte de connexion (P1) comporte une résistance de limitation (R0) du courant entre ladite patte de connexion et le noeud fonctionnel interne associé (N1) et un écrêteur de tension (e0) entre ce noeud fonctionnel interne (N1) et le substrat semi-conducteur (N0).

3. Circuit intégré selon la revendication 2 caractérisé en ce que la résistance de limitation (R0) et l'écrêteur de tension (e0) sont placés sur la patte de connexion (P1) à la première source de tension externe (V1) et caractérisé en ce que pour un transistor de sortie (Tp2) réalisé dans un caisson du deuxième type de dopage polarisé par la première référence interne de tension (Vref1), le drain (dp2) du transistor de sortie (Tp2) étant connecté à un noeud fonctionnel interne (N4) associé à une patte de connexion (P4) du circuit intégré, le dispositif de protection contre les surtensions associé (104) comporte une résistance de limitation du courant (R2) entre ladite patte de connexion (P4) et le noeud fonctionnel interne associé (N4) et l'écrêteur de tension (e0) associé à la patte de connexion (P1) à la première source de tension externe (V1).

4. Circuit intégré selon les revendications 2 à 3, caractérisé en ce qu'une résistance de limitation du courant d'un dispositif de protection contre les surtensions est réalisé par une diffusion (12) du second type de dopage dans une région plus vaste (13) qu'elle, du même second type de dopage mais moins dopé qu'elle (N$^+$), deux bornes de contact (b1, b2) de cette résistance de limitation du courant étant formées sur la diffusion (10).

5. Circuit intégré selon les revendications 2 à 4, caractérisé en ce qu'un écrêteur de tension (e0) d'un dispositif de protection contre les surtensions comporte deux diodes zener (z1, z2) en série.

6. Circuit intégré selon les revendications 1 à 5, caractérisé en ce que l'on place un dispositif de protection contre les décharges électrostatiques (201,...,205) entre chacune des pattes de connexion et le substrat semi-conducteur (N0).

7. Circuit intégré selon la revendication 6, caractérisé en ce que le dispositif de protection contre les décharges électrostatiques (205) associé à une patte de connexion (E1) est un transistor bipolaire latéral avec une base (bb), un émetteur (eb) et un collecteur (cb), la base et l'émetteur (eb) étant connectés au substrat semi-conducteur (N0), le collecteur étant connecté à la patte de connexion associée (E1), l'émetteur (eb) et le collecteur (cb) étant des diffusions du second type de dopage dans le substrat semi-conducteur, la diffusion du collecteur (ec) étant entièrement réalisée dans une région (14) plus vaste qu'elle, du même second type de dopage mais moins dopée qu'elle.

8. Circuit intégré selon la revendication 1, caractérisé en ce que la diode (D2) de connexion du substrat semi-conducteur (N0) à la patte de connexion (P2) à la deuxième source de tension externe (V2) est formée par le substrat semi-conducteur et une diffusion (10) d'un second type de dopage.

9. Circuit intégré selon la revendication 8, caractérisé en ce que la dite diffusion (10) de la diode (D2) de connexion est entièrement réalisée dans un caisson (11) d'un second type de dopage.

**EP 0 551 038 B1**

10. Procédé de fabrication d'un circuit intégré polarisé par une première source de tension externe (V1) délivrant une première référence de tension interne (Vref1) et une deuxième source de tension externe (V2), caractérisé en ce que l'on réalise dans un substrat semi-conducteur d'un premier type de dopage, une diffusion d'un second type de dopage (10), connectée à la deuxième source de tension externe (V2), et une résistance de polarisation (Rp) connectée sur une borne (b2) à la première référence de tension interne (Vref1) et sur l'autre borne (b1) à une diffusion du premier type de dopage (ps) pour polariser le substrat à une deuxième référence de tension interne (Vref2), le substrat et la diffusion d'un second type de dopage (10) formant une diode (D2) polarisée en direct en polarisation normale du circuit intégré et en inverse en polarisation inverse du circuit intégré, et le circuit intégré comprenant un dispositif de protection aux surtensions entre chaque patte de connexion externe et le substrat.


**Patentansprüche**

1. Integrierte Schaltung, die aus einem Halbleitersubstrat eines ersten Dotierungstyps hergestellt ist, Verbindungsbeinchen (P1, ..., P5) von internen Funktionsknoten (N1, ..., N5) zu externen Signalen (V1, V2, S1, S2, E1) umfaßt und über eine erste interne Referenzspannung (Vrefl) verfügt, die über ein Verbindungsbeinchen (P1) an eine erste externe Spannungsquelle (V1) abgegeben wird, wobei das Halbleitersubstrat auf eine zweite interne Bezugsspannung (Vref2) polarisiert ist, gekennzeichnet durch eine Vorrichtung (101, ..., 105) zum Schutz gegen die Überspannungen zwischen jedem der Verbindungsbeinchen (P1, ..., P5) und dem Halbleitersubstrat, eine zwischen dem Halbleitersubstrat und einem Verbindungsbeinchen (P2) mit einer zweiten externen Referenzspannungsquelle (V2) verbundene Diode (D2), und einen zwischen der ersten (Vref1) und der zweiten (Vref2) internen Bezugsspannung verschalteten Polarisationswiderstand (RP), so daß die Diode (D2) bei normaler Polarisation der integrierten Schaltung in Vorwärtsrichtung und bei umgekehrter Polarisation der integrierten Schaltung in Rückwärtsrichtung betrieben wird, um das Halbleitersubstrat von dem Verbindungsbeinchen (P2) an der zweiten externen Spannungsquelle, an dem es üblicherweise kurzgeschlossen wird, zu isolieren.

2. Integrierte Schaltung nach Anspruch 1, dadurch gekennzeichnet, daß eine einem Verbindungsbeinchen (P1) zugeordnete Vorrichtung (101) zum Schutz gegen die Überspannungen einen Strombegrenzungswiderstand (R0) zwischen dem Verbindungsbeinchen und dem zugeordneten internen Funktionsknoten (N1) und einen Spannungsbegrenzer (e0) zwischen diesem internen Funktionsknoten (N1) und dem Halbleitersubstrat (N0) umfaßt.

3. Integrierte Schaltung nach Anspruch 2, dadurch gekennzeichnet, daß der Begrenzungswiderstand (R0) und der Spannungsbegrenzer (e0) auf dem Verbindungsbeinchen (P1) zu der ersten externen Spannungsquelle (V1) angeordnet sind, und daß für einen Ausgangstransistor (Tp2), der in einer Senke des zweiten, durch die erste interne Spannungsquelle (Vref1) polarisierten Dotierungstyps ausgebildet ist, der Drain-Anschluß (dp2) des Ausgangstransistors (Tp2) mit einem einem Verbindungsbeinchen (P4) der integrierten Schaltung zugeordneten internen Funktionsknoten (N4) verbunden ist, und die zugeordnete Vorrichtung (104) zum Schutz gegen die Überspannungen einen Strombegrenzungswiderstand (R2) zwischen dem Verbindungsbeinchen (P4) und dem zugeordneten internen Funktionsknoten (N4) und dem dem Verbindungsbeinchen (P1) zu der ersten externen Spannungsquelle (V1) zugeordneten Spannungsbegrenzer (e0) umfaßt.

4. Integrierte Schaltung nach den Ansprüchen 2 bis 3, dadurch gekennzeichnet, daß ein Strombegrenzungswiderstand einer Vorrichtung zum Schutz gegen die Überspannungen durch eine Diffusion (12) des zweiten Dotierungstyps in einen Bereich (13) desselben zweiten Dotierungstyps ausgebildet wird, der zwar größer, jedoch weniger stark dotiert ist als sie ($N^+$), wobei zwei Kontaktierungsklemmen (b1, b2) dieses Strombegrenzungswiderstands auf der Diffusion (10) gebildet werden.

5. Integrierte Schaltung nach den Ansprüchen 2 bis 4, dadurch gekennzeichnet, daß ein Spannungsbegrenzer (e0) einer Vorrichtung zum Schutz gegen die Überspannungen zwei in Reihe geschaltete Zenerdioden (z1, z2) umfaßt.

6. Integrierte Schaltung nach den Ansprüchen 1 bis 5, dadurch gekennzeichnet, daß eine Vorrichtung zum Schutz gegen die elektrostatischen Entladungen (201, ..., 205) zwischen jedem der Verbindungsbeinchen und dem Halbleitersubstrat (N0) angeordnet wird.

7. Integrierte Schaltung nach Anspruch 6, dadurch gekennzeichnet, daß die einem Verbindungsbeinchen (E1) zugeordnete Vorrichtung (205) zum Schutz gegen die elektrostatischen Entladungen ein seitlich angeordneter, bipolarer Transistor mit einer Basis (bb), einem Emitter (eb) und einem Kollektor (cb) ist, wobei die Basis und der Emitter (eb) mit dem Halbleitersubstrat (N0) verbunden sind, der Kollektor mit dem zugeordneten Verbindungsbeinchen (E1) verbunden ist, der Emitter (eb) und der Kollektor (cb) aus Diffusionen des zweiten Dotierungstyps in das Halbleitersubstrat bestehen, und die Diffusion des Kollektors (ec) vollständig in einem Bereich (14) desselben zweiten Dotierungstyps ausgebildet ist, der zwar größer, jedoch weniger stark dotiert ist als sie.

8. Integrierte Schaltung nach Anspruch 1, dadurch gekennzeichnet, daß die Diode (D2) zur Verbindung des Halbleitersubstrats (N0) mit dem Verbindungsbeinchen (P2) zu der zweiten externen Spannungsquelle (V2) durch das Halbleitersubstrat und eine Diffusion (10) eines zweiten Dotierungstyps gebildet wird.

9. Integrierte Schaltung nach Anspruch 8, dadurch gekennzeichnet, daß die Diffusion (10) der Verbindungsdiode (D2) vollständig in einer Senke (11) eines zweiten Dotierungstyps ausgebildet ist.

10. Verfahren zur Herstellung einer integrierten Schaltung, die durch eine erste, eine erste interne Referenzspannung (Vref1) abgebende externe Spannungsquelle (V1) und durch eine zweite externe Spannungsquelle (V2) polarisiert wird, dadurch gekennzeichnet, daß in einem Halbleitersubstrat eines ersten Dotierungstyps eine Diffusion eines zweiten Dotierungstyps (10), die mit der zweiten externen Spannungsquelle (V2) verbunden ist, und ein Polarisationswiderstand (Rp), der an einer Anschlußklemme (b2) mit der ersten internen Bezugsspannung und an der anderen Anschlußklemme (b1) mit einer Diffusion des ersten Dotierungstyps (ps) verbunden ist, um das Substrat auf eine zweite interne Referenzspannung (Vref2) zu polarisieren, ausgebildet werden, wobei das Substrat und die Diffusion eines zweiten Dotierungstyps (10) eine Diode (D2) bilden, die bei normaler Polarisierung der integrierten Schaltung in Vorwärtsrichtung und bei umgekehrter Polarisierung der integrierten Schaltung in Rückwärtsrichtung betrieben wird, und die integrierte Schaltung eine Vorrichtung zum Schutz gegen die Überspannungen zwischen jedem der Verbindungsbeinchen und dem Substrat umfaßt.

## Claims

1. Integrated circuit produced from a semiconductor substrate of a first doping type, having lugs (P1, ..., P5) for connecting internal functional nodes (N1, ..., N5) to external signals (V1, V2, S1, S2, E1), the integrated circuit having a first internal voltage reference (Vref1) delivered by a lug (P1) connecting to a first external voltage source (V1), the semiconductor substrate being biased at a second internal voltage reference (Vref2), characterized in that it comprises a device (101, ..., 105) for protecting against overvoltages between each of the connecting lugs (P1, ..., P5) and the semiconductor substrate, a diode (D2) connected between the semiconductor substrate and a lug (P2) connecting to a second external reference voltage source, and a bias resistance (RP) connected between the first (Vref1) and the second (Vref2) internal voltage reference, so that the diode (D2) is forward biased when the integrated circuit is normally biased and reverse biased when the integrated circuit is reverse biased, to isolate the semiconductor substrate from the lug (P2) connecting to the second external voltage source to which it is habitually short-circuited.

2. Integrated circuit according to Claim 1, characterized in that a device (101) for protecting against overvoltages which is associated with a connecting lug (P1) has a resistance (R0) for limiting the current between the said connecting lug and the associated internal functional node (N1) and a voltage clipper (e0) between this internal functional node (N1) and the semiconductor substrate (N0).

3. Integrated circuit according to Claim 2, characterized in that the limiting resistance (R0) and the voltage clipper (e0) are placed on the lug (P1) connecting to the first external voltage source (V1), and characterized in that, for an output transistor (Tp2) produced in a casing of the second doping type biased by the first internal voltage reference (Vref1), the drain (dp2) of the output transistor (Tp2) being connected to an internal functional node (N4) associated with a connecting lug (P4) of the integrated circuit, the device for protecting against the associated overvoltages (104) has a resistance (R2) for limiting the current between the said connecting lug (P4) and the associated internal functional node (N4) and the voltage clipper (e0) associated with the lug (P1) connecting to the first external voltage source (V1).

4. Integrated circuit according to Claims 2 to 3, characterized in that a current-limiting resistance for a device for protecting against overvoltages is produced by a diffusion (12) of the second doping type in a region (13) larger than it, of the same second doping type but less doped that it ($N^+$), two contact terminals (b1, b2) of this current-limiting resistance being formed on the diffusion (10).

5. Integrated circuit according to Claims 2 to 4, characterized in that a voltage clipper (e0) for a device for protecting against overvoltages has two Zener diodes (z1, z2) in series.

6. Integrated circuit according to Claims 1 to 5, characterized in that a device for protecting against electrostatic discharges (201, ..., 205) is placed between each of the connecting lugs and the semiconductor substrate (N0).

7. Integrated circuit according to Claim 6, characterized in that the device protecting against electrostatic discharges (205) associated with a connecting lug (E1) is a lateral bipolar transistor with a base (bb), an emitter (eb), and a collector cb), the base and the emitter (eb) being connected to the semiconductor substrate (N0), the collector being connected to the associated connecting lug (E1), the emitter (eb) and the collector (cb) being diffusions of the second doping type in the semiconductor substrate, the diffusion of the collector (ec) being carried out entirely in a region (14) larger than itself, of the same second doping type but less doped than itself.

8. Integrated circuit according to Claim 1, characterized in that the diode (D2) for connecting the semiconductor substrate (N0) to the lug (P2) connecting to the second external voltage source (V2) is formed by the semiconductor substrate and a diffusion (10) of a second doping type.

9. Integrated circuit according to Claim 8, characterized in that the said diffusion (10) of the connecting diode (D2) is produced entirely in a casing (11) of a second doping type.

10. Method for manufacturing an integrated circuit biased by a first external voltage source (V1) delivering a first internal voltage reference (Vref1) and a second external voltage source (V2), characterized in that, in a semiconductor substrate of a first doping type, a diffusion of a second doping type (10) is produced, connected to the second external voltage source (V2), and a bias resistance (Rp) connected at one terminal (b2) to the first internal voltage reference (Vref1) and at the other terminal (b1) to a diffusion of the first doping type (ps) in order to bias the substrate at a second internal voltage reference (Vref2), the substrate and the diffusion of a second doping type (10) forming a diode (D2) forward biased when the integrated circuit is normally biased and reverse biased when the integrated circuit is reverse biased, and the integrated circuit comprising a device for protecting against overvoltages between each external connecting lug and the substrate.

# FIG_1

# FIG_2

FIG_3

FIG_4

FIG_5

FIG_6

FIG_7b

FIG_7a

FIG_8

FIG_9

FIG_10

FIG_11

FIG_12

FIG_13

FIG_14

FIG_15